# EUROPEAN PATENT APPLICATION

(11) **EP 4 068 934 A1**
(43) Date of publication of application: **05.10.2022**
(21) Application number: 22161756.6
(22) Date of filing: 14.03.2022
(51) Int. Cl.: H05K 7/20

(54) **LIQUID-COOLING HEAT DISSIPATION DEVICE AND POWER MODULE**

(30) Priority: 29.03.2021 CN 202110332682
(71) Applicant: Sungrow Power Supply Co., Ltd., Hefei, Anhui 230088 (CN)
(72) Inventor: CAO, Renxian, Hefei, 230088 (CN); HUANG, Nan, Hefei, 230088 (CN)
(74) Representative: Zacco Norway AS

(57) **Abstract**

A liquid-cooling heat dissipation device and a power module are provided. The liquid-cooling heat dissipation device includes a housing and a flow passage arranged inside the housing. A device mounting position for mounting a heating device is provided in the housing, the device mounting position includes a first mounting position and a second mounting position, the first mounting position is arranged on a first wall surface of the flow passage, and the second mounting position is arranged on a second wall surface of the flow passage.

## Description

### FIELD

The present application relates to the technical field of heat dissipation, and in particular to a liquid-cooling heat dissipation device and a power module including the liquid-cooling heat dissipation device.

### BACKGROUND

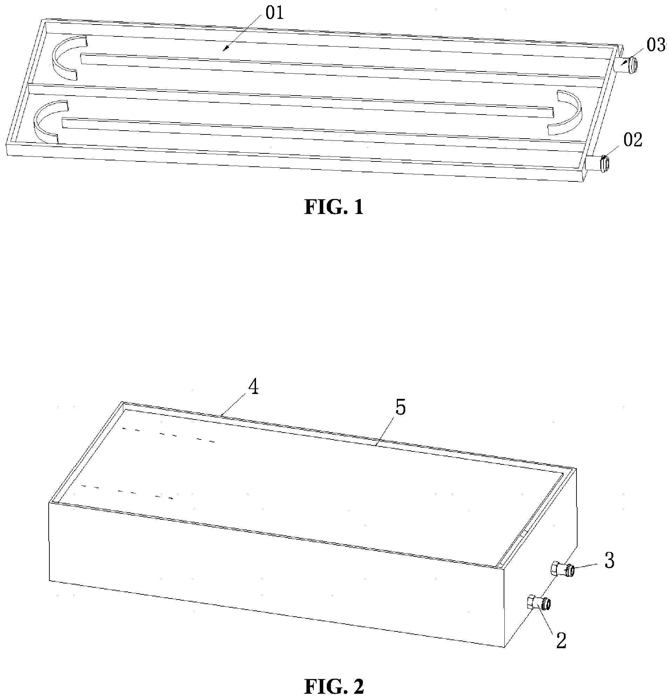

A conventional heating device, such as a power module, generally dissipates heat by liquid. As shown in FIG. 1, planar liquid-cooling heat dissipation is realized by a liquid-cooling heat dissipation device, a flow passage 01 is arranged at a bottom, and the heating device is arranged above the flow passage 01. FIG. 1 shows the flow passage 01 reversed by 180 degrees.

In the planar liquid-cooling heat dissipation method, the heating device is arranged above the flow passage 01, and thus only a bottom surface of the heating device is close to the flow passage, resulting in low heat dissipation efficiency.

Therefore, a technical problem to be urgently solved by those skilled in the art is how to improve the heat dissipation efficiency of the liquid-cooling heat dissipation device.

### SUMMARY

A liquid-cooling heat dissipation device is provided according to the present application, so as to improve heat dissipation efficiency of the liquid-cooling heat dissipation device. In addition, a power module including the liquid-cooling heat dissipation device is provided.

A liquid-cooling heat dissipation device is provided according to the present application. The device includes a housing and a flow passage arranged inside the housing. A device mounting position for mounting a heating device is provided in the housing, the device mounting position includes a first mounting position and a second mounting position, the first mounting position is arranged on a first wall surface of the flow passage, and the second mounting position is arranged on a second wall surface of the flow passage.

Preferably, a liquid inlet of the flow passage and a liquid outlet of the flow passage are arranged on a same end surface of the housing. Alternatively, the liquid inlet of the flow passage and the liquid outlet of the flow passage are arranged on different end surfaces of the housing.

Preferably, the number of the second mounting position is at least two.

Preferably, each of two second wall surfaces of the flow passage arranged oppositely is provided with the second mounting position.

Preferably, the number of the first mounting position is at least two, and each of two first wall surfaces of the flow passage arranged oppositely is provided with the first mounting position.

Preferably, the number of the first mounting position is more than one, and the more than one first mounting positions on the first wall surface on a same side of the flow passage are sequentially arranged along a coolant flow direction in the flow passage.

Preferably, the number of the flow passage is at least two.

Preferably, two adjacent flow passages are arranged in parallel.

Preferably, the at least two flow passages share a liquid inlet, and the at least two flow passages share a liquid outlet.

Preferably, the first wall surface of the single flow passage forms the first mounting position.

Preferably, the first wall surfaces of the at least two flow passages form the first mounting position.

Preferably, the housing includes a group of cooling plates stacked sequentially, a groove is defined on two opposite sides of the cooling plate at a middle of the group, and a groove is defined on only one side of the cooling plate at ends of the group, and edges of the grooves of two adjacent cooling plates are sealed to form the flow passage.

Preferably, the flow passage is a U-shaped flow passage, a liquid inlet and a liquid outlet of the flow passage are arranged on a same side of the housing, and arc-shaped portions of the U-shaped flow passage are arranged concentrically.

Preferably, along a coolant flow direction, the flow passage is a straight flow passage, a U-shaped flow passage or a curved flow passage.

Preferably, the flow passage extends to two opposite ends of the housing along a direction perpendicular to a coolant flow direction.

Preferably, a wall surface of the flow passage is provided with heat dissipation teeth.

Preferably, the liquid-cooling heat dissipation device further includes a sealing plate, a groove forming the flow passage is defined in the housing, the sealing plate blocks an open end of the groove, and two ends of the groove respectively form a liquid inlet and a liquid outlet.

Preferably, at least one of heat-conducting glue and an insulation heat-conducting sheet is arranged at the first mounting position.

Preferably, the first wall surface is a side wall of the flow passage, and the second wall surface is at least one of a top wall and a bottom wall of the flow passage.

Preferably, an included angle between the first wall surface and the second wall surface is an acute angle, a right angle or an obtuse angle.

A power module is further provided, which includes the liquid-cooling heat dissipation device described above and a heating device mounted at the device mounting position.

Preferably, the heating device includes a magnetic device and a power device, and the magnetic device and the power device are arranged at the first mounting positions located on two opposite sides of the flow passage.

Preferably, the heating device further includes a circuit board, the circuit board is mounted at the second mounting position, and the magnetic device and the power device are electrically connected to the circuit board.

Preferably, the circuit board includes a first circuit board and a second circuit board clamped between the first circuit board and the second mounting position, the flow passage is a U-shaped flow passage, a groove for mounting the magnetic device is defined in the flow passage, two opposite side walls of the magnetic device respectively abut against two opposite inner side walls of the flow passage, and the power device is mounted on an outer side wall of the flow passage.

Preferably, the power module is a charging pile.

In the above technical solution, the liquid-cooling heat dissipation device provided according to the present application includes the housing and the flow passage arranged inside the housing. The device mounting position for mounting a heating device is provided in the housing, the device mounting position includes the first mounting position and the second mounting position, the first mounting position is arranged on the first wall surface of the flow passage, and the second mounting position is arranged on the second wall surface of the flow passage.

It can be seen from the above description that in the liquid-cooling heat dissipation device provided according to the present application, the device mounting position includes the first mounting position and the second mounting position, the first mounting position is arranged on the first wall surface of the flow passage, the second mounting position is arranged on the second wall surface of the flow passage, the heating device can be mounted on the first mounting position and the second mounting position, thereby facilitating quick heat exchange between the heating device and a coolant, and thus improving the heat dissipation efficiency of the liquid-cooling heat dissipation device.

### BRIEF DESCRIPTION OF THE DRAWINGS

For illustrating embodiments of the present application or technical solutions in the conventional technology clearer, the drawings referred to for describing the embodiments or the conventional technology will be briefly described hereinafter. Apparently, the drawings in the following description show only some examples of the present application, and for those skilled in the art, other drawings may be obtained based on the provided drawings without any creative efforts.
FIG. 1 is a schematic structural view of a conventional liquid-cooling heat dissipation device;
FIG. 2 is an appearance view of a power module provided according to an embodiment of the present application;
FIG. 3 is an appearance view of a liquid-cooling heat dissipation device provided according to an embodiment of the present application;
FIG. 4 is a diagram showing arrangement of a first type of flow passage provided according to an embodiment of the present application;
FIG. 5 is a diagram showing a mounting position of a liquid-cooling heat dissipation device at which a circuit board of the power module is mounted according to an embodiment of the present application;
FIG. 6 is a diagram showing another mounting position of the liquid-cooling heat dissipation device at which a circuit board of the power module is mounted according to an embodiment of the present application;
FIG. 7 is a diagram showing mounting positions of a magnetic device and a power device of the power module according to an embodiment of the present application;
FIG. 8 is a sectional view of the power module provided according to an embodiment of the present application;
FIG. 9 is a diagram showing arrangement of a second type of flow passage provided according to an embodiment of the present application;
FIG. 10 is a diagram showing arrangement of a third type of flow passage provided according to an embodiment of the present application; and
FIG. 11 is a diagram showing arrangement of a fourth type of flow passage provided according to an embodiment of the present application.

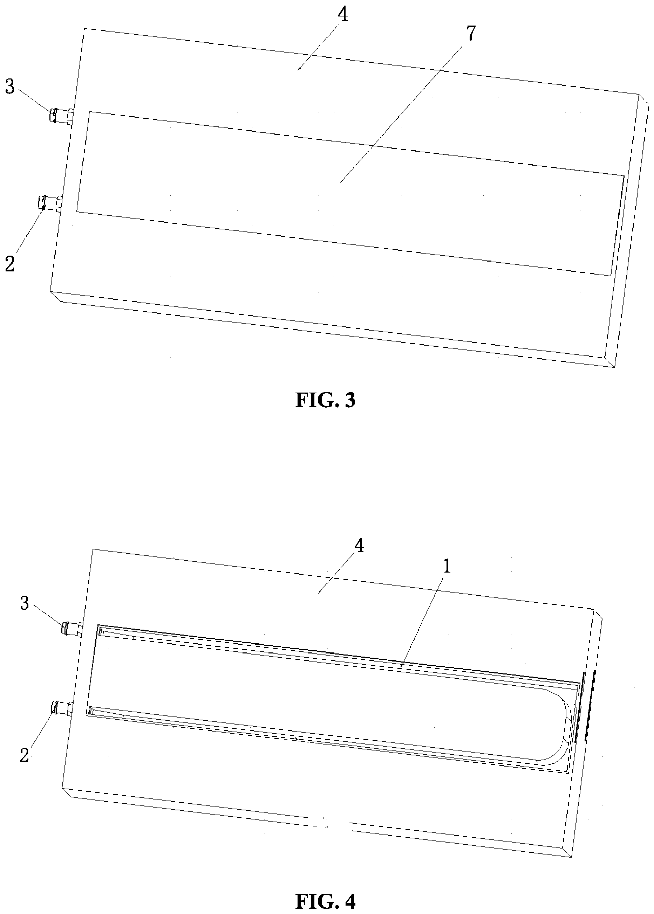

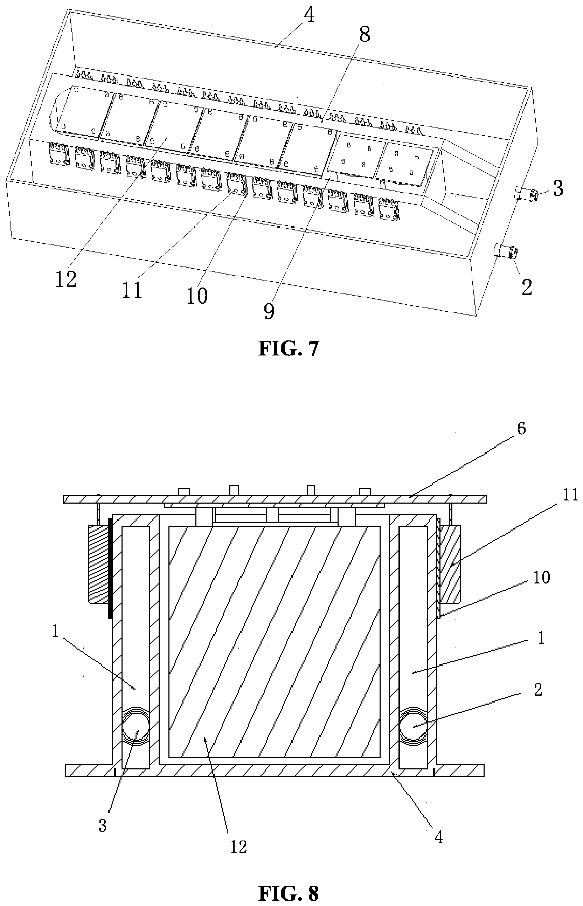

**Reference numerals in FIGS. 1 to 11 are listed as follows:**

| | |
|---|---|
| 01-flow passage, | 02-liquid inlet, |
| 03-liquid outlet; | |
| 1-flow passage, | 2-liquid inlet, |
| 3-liquid outlet, | 4-housing, |
| 5-first circuit board, | 6-second circuit board, |
| 7-flow passage cover plate, | 8-outer side wall, |
| 9-heat-conducting glue, | 10-insulation heat-conducting sheet, |
| 11-power device, | 12-magnetic device, |
| 13-heat dissipation tooth. | |

### DETAILED DESCRIPTION OF THE EMBODIMENTS

A liquid-cooling heat dissipation device is provided, so as to improve the heat dissipation efficiency of the liquid-cooling heat dissipation device. Further, a power module including the above liquid-cooling heat dissipation device is provided.

In order to enable those skilled in the art to better understand the technical solutions of the present application, the present application will be further described in detail below with reference to the accompanying drawings and embodiments.

Reference is made to FIGS. 2 to 11.

In an embodiment, a liquid-cooling heat dissipation device is provided according to the present application. The device includes a housing 4 and a flow passage 1 arranged inside the housing 4. A device mounting position for mounting a heating device is provided in the housing 4. The device mounting position includes a first mounting position and a second mounting position. The first mounting position is arranged on a first wall surface of the flow passage 1, and the second mounting position is arranged on a second wall surface of the flow passage 1. The number of the flow passage 1 may be one.

In some embodiments, the housing 4 may be provided with at least two flow passages 1. The first wall surface may be a facade of the flow passage 1, that is, the first wall surface is a side wall of the flow passage 1. The second wall surface is a top wall and/or a bottom wall of the flow passage 1. Specifically, the second wall surface may be a top surface of the flow passage 1.

The first wall surface and the second wall surface may be curved surfaces. Preferably, the first wall surface and the second wall surface may be flat surfaces. An included angle between the first wall surface and the second wall surface is an acute angle, a right angle or an obtuse angle.

The liquid-cooling heat dissipation device may be applied to a charging pile.

Along a coolant flow direction, the flow passage 1 may be a straight flow passage, a U-shaped flow passage or a curved flow passage.

The wall surface of the flow passage 1 is provided with heat dissipation teeth 13. An outer side wall 8 and an inner side wall of the flow passage 1 are provided with the heat dissipation teeth 13. The heating device may be a magnetic device 12 or a power device 11, or the like. The heat dissipation teeth 13 are preferably mounted on the first wall surface.

The heat dissipation teeth 13 may be integrally formed with the flow passage 1, or the heat dissipation teeth 13 may be bonded to the flow passage 1. The heat dissipation teeth 13 may be arranged sequentially along a coolant flow direction, and a distance between two adjacent heat dissipation teeth 13 may be fixed or variable.

Preferably, the heat dissipation teeth 13 are mounted at an edge of the first mounting position, so as to avoid interference with the heating device mounted at the first mounting position. In a case that the heat dissipation tooth 13 is arranged on a side wall of the flow passage 1, preferably, the heat dissipation tooth 13 extends to an upper end and a lower end of the flow passage 1.

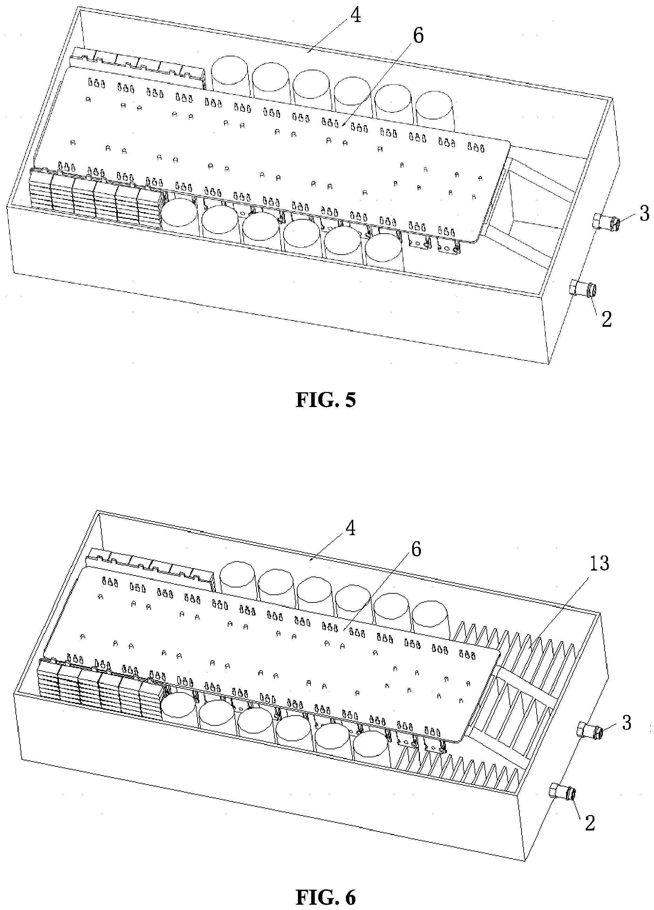

In another embodiment, as shown in FIGS. 5, 7 and 11, a liquid inlet 2 of the flow passage 1 and a liquid outlet 3 of the flow passage 1 are arranged on a same end surface of the housing 4.

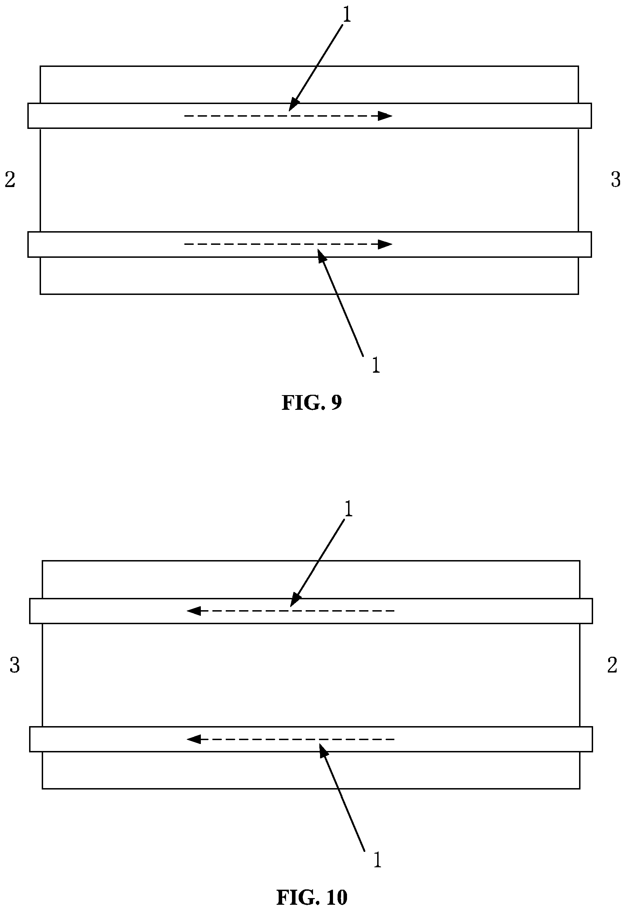

In another embodiment, as shown in FIGS. 9 and 10, the liquid inlet 2 of the flow passage 1 and the liquid outlet 3 of the flow passage 1 are arranged on different end surfaces of the housing 4. In a case that the liquid inlet 2 and the liquid outlet 3 are arranged on different end surfaces of the housing 4, the liquid inlet 2 and the liquid outlet 3 may be arranged on two end surfaces of the housing 4 arranged oppositely, or arranged on two adjacent end surfaces of the housing 4.

The flow passage 1 surrounds and contacts the heating device, so as to dissipate heat by the heating device.

The flow passage 1 may be formed by casting, or be formed by sealing edges of two structures. Specifically, the flow passage 1 may have a water groove structure. An opening of the flow passage 1 faces a top of the housing 4, and a top of the flow passage 1 is integrated with a periphery of the flow passage 1 through a flow passage cover plate 7 by friction stir welding, so as to maintain the sealing of the flow passage 1. The liquid inlet 2 and the liquid outlet 3 are defined on an outer side wall of the housing 4, and the liquid inlet 2 and the liquid outlet 3 are connected to the flow passage 1. The flow passage 1 receives external circulating coolant, and the circulating coolant enters the flow passage 1 to cool the housing 4 and the heating device.

As shown in FIG. 5, a welding seam is exposed to show the flow passage cover plate 7. In fact, the flow passage cover plate 7 is integrated with the housing 4 after welding. The flow passage 1 is arranged longitudinally in a middle of the housing 4, and is a longitudinal U-shaped flow passage in this solution.

In another embodiment, the housing 4 includes a group of cooling plates stacked sequentially. In a case that the cooling plates are sequentially arranged from top to bottom, the multiple flow passages 1 are sequentially arranged from top to bottom. A groove is defined on two opposite sides of the cooling plate at a middle of the group, and a groove is defined on only one side of the cooling plate at ends of the group, and edges of the grooves of two adjacent cooling plates are sealed to form the flow passage 1.

It can be known from the above description that, in the liquid-cooling heat dissipation device provided according to the embodiments of the present application, the device mounting position includes the first mounting position and the second mounting position. The first mounting position is arranged on the first wall surface of the flow passage, the second mounting position is arranged on the second wall surface of the flow passage, and the heating device can be mounted at the first mounting position and the second mounting position. In this case, the flow passage 1 is in full contact with the heating device, and a contact area is increased, thereby facilitating quick heat exchange between the heating device and the coolant, and thus improving the heat dissipation efficiency of the liquid-cooling heat dissipation device.

The number of the second mounting position may be one. The number of the second mounting positions may preferably be at least two in a case that multiple heating devices need to be mounted on the second wall surface. The at least two second mounting positions may be provided on a same second wall surface of the flow passage 1, for example, on an upper end surface of the flow passage 1. Alternatively, each of two second wall surfaces of the flow passage 1 arranged oppositely is provided with the second mounting position, for example, both an upper end surface and a lower end surface of the flow passage 1 are provided with the second mounting positions.

In order to further improve the heat dissipation efficiency, preferably, two side walls of the flow passage 1 arranged oppositely form the first wall surface. For example, both a left side wall and a right side wall of the flow passage 1 are provided with the first mounting positions.

Preferably, multiple first mounting positions are provided, and the first mounting positions on the first wall surface on a same side of the flow passage 1 are sequentially arranged along a coolant flow direction in the flow passage 1. Preferably, a distance between two adjacent first mounting positions is fixed.

Two adjacent flow passages 1 are arranged in parallel. For example, as shown in FIGS. 9 and 10, the flow passage 1 is a straight flow passage. The flow passage 1 may be a curved flow passage, such as arc-shaped or wave-shaped.

At least two flow passages 1 share the liquid inlet 2, and at least two flow passages 1 share the liquid outlet 3. Preferably, all the flow passages 1 share the liquid inlet 2, and/or all the flow passages 1 share the liquid outlet 3, that is, only one liquid inlet 2 and one liquid outlet 3 need to be defined on the housing 4.

The first wall surface of the single flow passage 1 forms the first mounting position. The multiple flow passages 1 are sequentially arranged along a width direction of the housing 4. Specifically, side walls of the flow passage 1 may extend to two opposite ends of the housing 4.

The first wall surfaces of multiple flow passages 1 form the first mounting position. The multiple flow passages 1 are sequentially arranged along a height direction of the housing 4. The first mounting position extends to an upper end and a lower end of the housing 4 along the height direction.

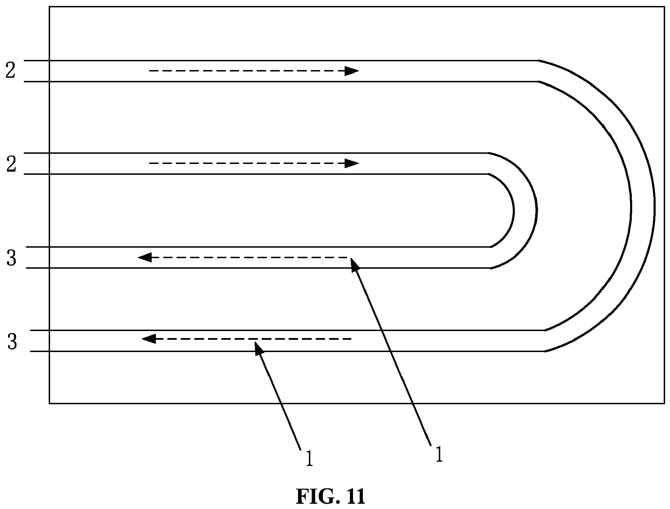

In an embodiment, as shown in FIG. 11, the flow passage 1 may be a U-shaped flow passage, the liquid inlet 2 and the liquid outlet 3 of the flow passage 1 are arranged on a same side of the housing 4, and arc-shaped portions of the U-shaped flow passage are arranged concentrically. The heating device is arranged between two adjacent flow passages 1, and heat-conducting glue 9 is also arranged between two adjacent flow passages 1. Specifically, the heat-conducting glue 9 may be filled between the heating device and the first mounting position.

The flow passage 1 may extend to two opposite ends of the housing 4 along a direction perpendicular to the coolant flow direction. For example, in a case that the coolant flows horizontally, the flow passage 1 extends along the height direction, thereby increasing the heat dissipation area.

The housing 4 is formed by die-casting or casting. Preferably, the housing 4 and the flow passage cover plate 7 are made of metal.

In order to improve the heat dissipation effect, the heat-conducting glue 9 and/or an insulation heat-conducting sheet 10 is provided at the first mounting position. Specifically, the insulation heat-conducting sheet 10 may be a heat-conducting silicone sheet or a ceramic sheet. The heat-conducting glue 9 is filled in a gap between a magnetic device 12 and the flow passage 1, thereby greatly accelerating the heat exchange between the magnetic device 12 and the flow passage 1. In the present application, the power device 11 in the heating device may be arranged on the outer side wall 8 of the flow passage 1 and heat exchange is performed between the power device 11 and the flow passage 1 through the insulation heat-conducting sheet 10, thereby greatly improving the heat dissipation efficiency of the power device 11.

A power module is provided according to the present application, which includes the liquid-cooling heat dissipation device described above and a heating device. The heating device is mounted on the device mounting position. The specific structure of the liquid-cooling heat dissipation device has been described above. Since the power module includes the liquid-cooling heat dissipation device, the power module can achieve the above technical effects.

The heating device includes a magnetic device 12 and a power device 11, and the magnetic device 12 and the power device 11 are arranged at the first mounting positions located on two opposite sides of the flow passage 1.

The heating device further includes a circuit board, the circuit board is mounted at the second mounting position, and the magnetic device 12 and the power device 11 are electrically connected to the circuit board.

A body of the housing 4 is a cuboid with an opening on an upper end surface, and upper and lower circuit boards are provided in the housing 4. The circuit boards include a first circuit board 5 and a second circuit board 6 clamped between the first circuit board 5 and the second mounting position, the flow passage 1 is arranged in the middle of the housing 4, and the flow passage 1 is arranged longitudinally. The first circuit board includes a main power board and a control board, and the main power board and the control board may be an integrated circuit board. The second circuit board may be an inductive transformer board.

The flow passage 1 is a U-shaped flow passage, a groove for mounting the magnetic device 12 is defined in the flow passage 1, and the power device 11 is mounted on the outer side wall 8 of the flow passage 1. Preferably, two opposite side walls of the magnetic device 12 respectively abut against two opposite inner side walls of the flow passage 1, that is, one side wall of the magnetic device 12 abuts against one inner side wall of the flow passage 1, and the other side wall of the magnetic device 12 abuts against the other inner side wall of the flow passage 1.

In an embodiment, the power module may be a charging pile.

The above embodiments are described in a progressive manner. Each of the embodiments is mainly focused on describing its differences from other embodiments, and for the same or similar parts of the embodiments, one may refer to the description of other embodiments.

According to the above description of the disclosed embodiments, those skilled in the art can implement or practice the present disclosure. Many modifications to these embodiments are apparent for those skilled in the art, and general principles defined herein may be implemented in other embodiments without departing from the spirit or scope of the present disclosure. Hence, the present disclosure is not limited to the embodiments disclosed herein, but is to conform to the widest scope in accordance with the principles and novel features disclosed herein.

## Claims

1. A liquid-cooling heat dissipation device, comprising:
a housing (4); and
a flow passage (1) arranged inside the housing (4), wherein
a device mounting position for mounting a heating device is provided in the housing (4), the device mounting position comprises a first mounting position and a second mounting position, the first mounting position is arranged on a first wall surface of the flow passage (1), and the second mounting position is arranged on a second wall surface of the flow passage (1).

2. The liquid-cooling heat dissipation device according to claim 1, wherein a liquid inlet (2) of the flow passage (1) and a liquid outlet (3) of the flow passage (1) are arranged on a same end surface of the housing (4); or
the liquid inlet (2) of the flow passage (1) and the liquid outlet (3) of the flow passage (1) are arranged on different end surfaces of the housing (4).

3. The liquid-cooling heat dissipation device according to claim 1, wherein the number of the second mounting position is at least two.

4. The liquid-cooling heat dissipation device according to claim 3, wherein each of two second wall surfaces of the flow passage (1) arranged oppositely is provided with the second mounting position.

5. The liquid-cooling heat dissipation device according to claim 1, wherein the number of the first mounting position is at least two, and each of two first wall surfaces of the flow passage (1) arranged oppositely is provided with the first mounting position;
the number of the first mounting position is more than one, and the more than one first mounting positions on the first wall surface on a same side of the flow passage (1) are sequentially arranged along a coolant flow direction in the flow passage (1).

6. The liquid-cooling heat dissipation device according to claim 1, wherein the number of the flow passages (1) is at least two.

7. The liquid-cooling heat dissipation device according to claim 6, wherein the at least two flow passages (1) share a liquid inlet (2), and the at least two flow passages (1) share a liquid outlet (3).

8. The liquid-cooling heat dissipation device according to claim 6, wherein the first wall surface of the single flow passage (1) forms the first mounting position.

9. The liquid-cooling heat dissipation device according to claim 6, wherein the first wall surfaces of the at least two flow passages (1) form the first mounting position.

10. The liquid-cooling heat dissipation device according to claim 9, wherein the housing (4) comprises a group of cooling plates stacked sequentially, a groove is defined on two opposite sides of the cooling plate at a middle of the group, and a groove is defined on only one side of the cooling plate at ends of the group, and edges of the grooves of two adjacent cooling plates are sealed to form the flow passage (1).

11. The liquid-cooling heat dissipation device according to claim 6, wherein the flow passage (1) is a U-shaped flow passage, a liquid inlet (2) and a liquid outlet (3) of the flow passage (1) are arranged on a same side of the housing (4), and arc-shaped portions of the U-shaped flow passage are arranged concentrically.

12. The liquid-cooling heat dissipation device according to claim 1, wherein the flow passage (1) extends to two opposite ends of the housing (4) along a direction perpendicular to a coolant flow direction.

13. The liquid-cooling heat dissipation device according to claim 1, further comprising a sealing plate, wherein a groove forming the flow passage (1) is defined in the housing (4), the sealing plate blocks an open end of the groove, and two ends of the groove respectively form a liquid inlet (2) and a liquid outlet (3).

14. The liquid-cooling heat dissipation device according to claim 1, wherein the first wall surface is a side wall of the flow passage (1), and the second wall surface is at least one of a top wall and a bottom wall of the flow passage (1).

15. A power module, comprising the liquid-cooling heat dissipation device according to any one of claims 1 to 14 and a heating device mounted at the device mounting position.
